# EUROPEAN PATENT APPLICATION

(11) **EP 4 835 491 A1**
(43) Date of publication of application: **04.11.2026**
(21) Application number: 24912069.2
(22) Date of filing: 14.11.2024
(51) Int. Cl.: G01R 1/073, C08K 3/22, C08L 79/08, C08L 101/12, G01R 31/26, G01R 31/28, H01L 21/66, H05K 3/00

(54) **MEMBER FOR PROBE CARD OR MEMBER FOR PRINTED CIRCUIT BOARD INSPECTION JIG, AND METHOD FOR MANUFACTURING SAME**

(30) Priority: 25.12.2023 JP 2023217719
(71) Applicant: MITSUBISHI GAS CHEMICAL COMPANY, INC., Chiyoda-ku Tokyo 100-8324 (JP)
(72) Inventor: SATO, Yuuki, Hiratsuka-shi, Kanagawa 254-0016 (JP); SAKAI, Atsushi, Hiratsuka-shi, Kanagawa 254-0016 (JP)
(74) Representative: Vossius & Partner Patentanwälte Rechtsanwälte mbB
(86) International application number: PCT/JP2024/040406
(87) International publication number: WO 2025/142176

(57) **Abstract**

A member for a probe card or a member for a printed board inspection jig, and method for producing thereof, wherein the member is composed of a thermoplastic resin composition containing: a component (A) which is at least one thermoplastic resin selected from the group consisting of a crystalline thermoplastic resin (al) having a melting point of 270°C or more and an amorphous thermoplastic resin (a2) having a glass transition temperature of 200°C or more; and a component (B) which is an inorganic filler including a zirconium oxide (b1), and wherein a content of the component (b 1) is 2 to 40 parts by mass with respect to 100 parts by mass of the component (A), and a content of the component (B) is 2 to 60 parts by mass with respect to 100 parts by mass of the component (A).

## Description

### Technical Field

The present invention relates to a member for a probe card or a member for a printed board inspection jig, as well as a production method thereof.

### Background Art

Engineering plastics are thermoplastic resins that have various excellent properties such as formability, heat resistance, and strength, and are used in a wide range of fields such as automobile parts, mechanical parts, and electrical and electronic parts.

Thermoplastic resin compositions containing a functional filler are also known as engineering plastics. For example, Patent Literature 1 describes that a low-contamination injection-molded article formed from a resin composition formed containing predetermined amounts of each of a thermoplastic resin component containing a crystalline thermoplastic resin and an amorphous thermoplastic resin, a carbon precursor, and a conductive filler is capable of strictly controlling surface resistivity to a desired value within the semiconductive region, and that the amount of foreign particles generated is extremely small.

Patent Literature 2 discloses that a flame-retardant polyimide molding material containing a semi-aromatic polyimide resin and predetermined amounts of graphite, carbon fiber, and the like has excellent formability and can exhibit high flame retardancy.

Moreover, in devices using contact probe pins, such as a wafer inspection probe card or a printed board inspection jig, it is known to use a plate-shaped thermoplastic resin molded article obtained by machine processing a large number of precise holes into a super engineering plastic molded article or a ceramic molded article for a holding portion or a guide portion of the contact probe pins (for example, see Patent Literature 3).

However, when holes are formed in a thermoplastic resin molded article, there is a problem in that burrs occur around the openings that have been formed. Patent Literature 3 discloses that this problem can be solved by using a drill bit having a specific diameter when forming holes in a resin molded article obtained by molding a resin composition containing a thermoplastic resin having predetermined thermal properties.

### Citation List

### Patent Literature

PTL 1: JP2005-290328 A
PTL 2: WO 2021/024624 A1
PTL 3: JP2007-90492 A

### Summary of Invention

### Technical Problem

The machining process method for a thermoplastic resin molded article relating to the technology disclosed in Patent Literature 3 involves forming holes in the resin molded article with a drill bit. However, when the formation of finer holes is required in a member for a probe cards or a member for a printed board inspection jig, there are limits to the precision that can be achieved with a machining process using a drill.

A laser processing allows for finer processing than a machining process using a drill. However, the physical properties required of the thermoplastic resin molded article being processed may vary depending on the processing method.

An object of the present invention is to provide a member for a probe card or a member for a printed board inspection jig, as well as a production method thereof, that has undergone high-precision microfabrication with little occurrence of burrs or the like, particularly when fine through-holes are formed by a laser processing.

### Solution to Problem

The present inventors have found that the aforementioned object can be attained by using a predetermined thermoplastic resin composition for a member for a probe card or a member for a printed board inspection jig, as well as production thereof.

That is, the present invention relates to the following.
[1] A member for a probe card or a member for a printed board inspection jig, the member being composed of a thermoplastic resin composition containing:
   a component (A) which is at least one thermoplastic resin selected from the group consisting of a crystalline thermoplastic resin (a1) having a melting point of 270°C or more and an amorphous thermoplastic resin (a2) having a glass transition temperature of 200°C or more; and
   a component (B) which is an inorganic filler including a zirconium oxide (b1), wherein
   a content of the component (b1) is 2 to 40 parts by mass with respect to 100 parts by mass of the component (A), and a content of the component (B) is 2 to 60 parts by mass with respect to 100 parts by mass of the component (A).
[2] The member according to the above [1], wherein the component (a1) includes a polyimide resin (a1-1) containing a repeating structural unit represented by the following formula (1) and a repeating structural unit represented by the following formula (2), a content ratio of the repeating structural unit of formula (1) to the total of the repeating structural unit of formula (1) and the repeating structural unit of formula (2) being 20 to 70 mol%: 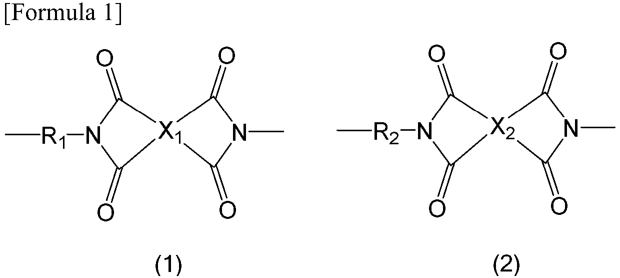 wherein R₁ represents a divalent group having from 6 to 22 carbon atoms containing at least one alicyclic hydrocarbon structure; R₂ represents a divalent chain aliphatic group having from 5 to 16 carbon atoms; and X₁ and X₂ each independently represent a tetravalent group having from 6 to 22 carbon atoms containing at least one aromatic ring.
[3] The member according to the above [1] or [2], wherein the zirconium oxide (b1) has a volume median diameter (D50) of 1 µm or less.
[4] The member according to any one of the above [1] to [3], wherein a total content of the component (A) and the component (B) in the thermoplastic resin composition is 50% by mass or more.
[5] The member according to any one of the above [1] to [4], wherein the component (B) further includes an inorganic filler (b2) other than the component (b1), and the component (b2) includes at least one selected from the group consisting of talc, mica, silica, alumina, silicon nitride, aluminum nitride, boron nitride, silicon carbide, boron carbide, calcium carbonate, and titanium oxide.
[6] The member according to the above [5], wherein a content of the inorganic filler (b2) is 1 to 40 parts by mass with respect to 100 parts by mass of the component (A) in the thermoplastic resin composition.
[7] The member according to any one of the above [1] to [6], wherein the member is a member having a plate-like portion, and having, on the plate-like portion, a plurality of through-holes, each of which has a substantially circular opening with a diameter of 400 µm or less or a substantially square opening with a side length of 400 µm or less.
[8] The member according to any one of the above [1] to [7], wherein the member is a holding member of a probe or a guide member of a probe.
[9] A method for producing the member for a probe card or the member for a printed board inspection jig according to any one of the above [1] to [8], including the following step (I) and step (II) in this order:
   Step (I): a step of molding a thermoplastic resin composition by a thermoforming method to obtain a molded article having a plate-like portion, the thermoplastic resin composition containing:
      a component (A) which is at least one thermoplastic resin selected from the group consisting of a crystalline thermoplastic resin (a1) having a melting point of 270°C or more and an amorphous thermoplastic resin (a2) having a glass transition temperature of 200°C or more; and
      a component (B) which is an inorganic filler including a zirconium oxide (b1), wherein
      a content of the component (b1) is 2 to 40 parts by mass with respect to 100 parts by mass of the component (A), and a content of the component (B) is 2 to 60 parts by mass with respect to 100 parts by mass of the component (A),
   Step (II): a step of forming a plurality of through-holes in the plate-like portion of the molded article by a machining process or a laser processing.
[10] The production method according to the above [9], wherein the thermoforming method in step (I) is an injection molding method, an extrusion method, or a compression molding method.
[11] The production method according to the above [9] or [10], wherein a processing method in step (II) is a laser processing.

### Advantageous Effects of Invention

According to the present invention, it is possible to provide a member for a probe card or a member for a printed board inspection jig, as well as a production method thereof, that has undergone high-precision microfabrication with little occurrence of burrs or the like, particularly when fine through-holes are formed by a laser processing.

### Brief Description of Drawings

[Fig. 1] Fig. 1 is a schematic plan view of a molded article 200 produced in step (I) of Example 1.
[Fig. 2] Fig. 2 is an observation image of through-holes having a circular opening shape produced in Example 1.
[Fig. 3] Fig. 3 is an observation image of through-holes having a square opening shape produced in Example 1.
[Fig. 4] Fig. 4 is an observation image of through-holes having a circular opening shape produced in Example 2.
[Fig. 5] Fig. 5 is an observation image of through-holes having a square opening shape produced in Example 2.

### Description of Embodiments

### [Definitions]

As used herein, "(a member) that has undergone high-precision microfabrication" means that a large number of through-holes are formed at a narrow pitch in the member, there is little fracture of the partitions between the openings of the through-holes, there is little occurrence of discoloration or burrs, there is little variation in the shape of the openings, and further, when the shape of the openings is square, the corners are not rounded, and the shape reproducibility is high. The "through-holes" referred to here are fine through-holes having an opening diameter or side length of preferably 400 µm or less, more preferably 200 µm or less, further preferably 100 µm or less, still further preferably less than 50 µm, still further preferably 40 µm or less, and still further preferably 30 µm or less. In addition, "narrow pitch" referred to here means, for example, a pitch in the range of more than 1 time and 5 times or less of the diameter of the openings or side length of the openings.

Specifically, the microfabrication precision of the member can be evaluated using the method described in the Examples.

### [Member for a probe card or member for a printed board inspection jig]

The member for a probe card or member for a printed board inspection jig of the present invention (hereinafter simply referred to as the "member (of the present invention)") is composed of a thermoplastic resin compound containing:
a component (A) which is at least one thermoplastic resin selected from the group consisting of a crystalline thermoplastic resin (a1) having a melting point of 270°C or more and an amorphous thermoplastic resin (a2) having a glass transition temperature of 200°C or more; and
a component (B) which is an inorganic filler including a zirconium oxide (b1), wherein
a content of the component (b1) is 2 to 40 parts by mass with respect to 100 parts by mass of the component (A), and a content of the component (B) is 2 to 60 parts by mass with respect to 100 parts by mass of the component (A). As described later, the zirconium oxide (b1) preferably has a volume median diameter (D50) of 1 µm or less.

With the above-described configuration, the present invention can provide a member for a probe card or a member for a printed board inspection jig that has undergone high-precision microfabrication, and that has few burrs, in particular even when fine through-holes are formed by a laser processing.

Although the reason why the above effects are obtained in the present invention is not clear, it is presumed to be as follows.

The member of the present invention is composed of the above-described thermoplastic resin composition, and the composition contains, as the thermoplastic resin (A), at least one selected from the group consisting of a crystalline thermoplastic resin (a1) having a melting point of 270°C or more and an amorphous thermoplastic resin (a2) having a glass transition temperature of 200°C or more. As a result of the thermoplastic resin composition containing the component (A), a member of any desired shape can be easily produced by thermoforming. Further, when the member of the present invention is, for example, a holding member of a probe or a guide member of a probe, a step is required in which the thermoplastic resin is thermoformed to produce a molded article, and then fine through-holes are formed at a narrow pitch in the molded article by a machining process by using a drill, a laser processing, or the like. Here, if the thermoplastic resin (A) has a predetermined or higher heat resistance, the thermoplastic resin (A) will be able to withstand the thermal energy generated during the machining process by using a drill or laser processing when the fine through-holes are formed in the molded article composed of the thermoplastic resin composition. As a result, it is presumed that melting and dimensional changes during the processing of the molded article can be suppressed, and fine through-holes can be formed with high precision.

In addition, the thermoplastic resin composition contains a predetermined amount of an inorganic filler as the component (B), and the inorganic filler contains zirconium oxide (b1). By using submicron-level fine zirconium oxide (b1) particles as the inorganic filler, asperities caused by the particles of the resulting molded article are suppressed, and when the fine through-holes are formed in the molded article, the wall surfaces of the fine through-holes maintain their smoothness, which is thought to improve the microfabrication precision and suppress, for example, fracture of the partitions between the through-hole openings and variation in the shape of the openings. It is presumed that by including a predetermined amount of a high-hardness component (b1) relative to the thermoplastic resin (A), the material becomes appropriately brittle and the occurrence of burrs can be suppressed.

As used herein, a "member for a probe card" refers to a member that constitutes at least a part of a probe card, and a "member for a printed board inspection jig" refers to a member that constitutes at least a part of a printed board inspection jig.

A probe card is a device used in the so-called front-end process of semiconductor manufacturing, and a printed board inspection jig is a tool used to inspect printed boards. Therefore, these members are different from members for inspection of IC sockets, which are used in the back-end process of semiconductor manufacturing.

The member of the present invention is not particularly limited as long as it is a member for a probe card or a member for a printed board inspection jig. However, from the viewpoint of requiring high-precision microfabrication, the member of the present invention is preferably a holding member of a probe or a guide member of a probe in a member for a probe card or a member for a printed board inspection jig.

The shape of the member of the present invention preferably has a plate-like portion and a plurality of through-holes penetrating the plate-like portion in the thickness direction.

More specifically, the member of the present invention is a member preferably having a plate-like portion, and having, on the plate-like portion, a plurality of through-holes, each of which has a substantially circular opening with a diameter of 400 µm or less or a substantially square opening with a side length of 400 µm or less. The diameter of the openings or side length of the openings is more preferably 200 µm or less, further more preferably 100 µm or less, still further preferably less than 50 µm, still further preferably 40 µm or less, and still further preferably 30 µm or less.

Further, the diameter of the openings or the side length of the openings is preferably 5 µm or more, more preferably 10 µm or more, from the viewpoint of using as a holding member of a probe or a guide member of a probe.

The plurality of through-holes are preferably arranged regularly, and the pitch of the through-holes is, for example, in the range of more than 1 time and 5 times or less of the diameter of the openings or the side length of the openings, and more preferably in the range of 1.1 to 3 times.

The diameter of the openings, the side length of the openings, and the pitch can be measured, for example, by the method described in the Examples using a high-resolution image dimension measuring device.

The through-holes do not need to be formed over the entire surface of the plate-like portion, and it is sufficient if the through-holes are formed in at least a portion of the plate-like portion.

### <Thermoplastic resin composition>

The thermoplastic resin composition constituting the member of the present invention contains a component (A) which is at least one thermoplastic resin selected from the group consisting of a crystalline thermoplastic resin (a1) having a melting point of 270°C or more and an amorphous thermoplastic resin (a2) having a glass transition temperature of 200°C or more, and a component (B) which is an inorganic filler including a zirconium oxide (b1), wherein a content of the component (b1) is 2 to 40 parts by mass with respect to 100 parts by mass of the component (A), and a content of the component (B) is 2 to 60 parts by mass with respect to 100 parts by mass of the component (A).

### <Thermoplastic resin (A)>

The thermoplastic resin (A) used in the present invention (hereinafter also simply referred to as "component (A)" or "thermoplastic resin (A)") is at least one selected from the group consisting of a crystalline thermoplastic resin (a1) having a melting point of 270°C or more and an amorphous thermoplastic resin (a2) having a glass transition temperature of 200°C or more.

As used herein, "crystalline thermoplastic resin" refers to a resin that has a melting point and a glass transition temperature, and "amorphous thermoplastic resin" refers to a resin that has a glass transition temperature but does not have a melting point. It is noted that resins that are essentially crystalline but have an extremely slow crystallization rate, and can only be processed in an amorphous state using various forming methods, are classified as being an amorphous thermoplastic resin.

### (Crystalline thermoplastic resin (a1))

The crystalline thermoplastic resin (a1) (hereinafter also simply referred to as "component (a1)") used as component (A) is a crystalline thermoplastic resin having a melting point of 270°C or more from the viewpoint of producing a member that has undergone high-precision microfabrication.

The melting point of the component (a1) is preferably 280°C or more, more preferably 290°C or more, and further preferably 300°C or more, from the viewpoint of producing a member that has undergone high-precision microfabrication. In addition, the melting point is preferably 400°C or less, more preferably 380°C or less, and further preferably 350°C or less, from the viewpoint of ease of thermoforming.

The melting point of the component (a1) can be measured using a differential scanning calorimeter, and specifically by the method described in the examples.

The glass transition temperature (Tg) of the component (a1) is not particularly limited, but is preferably 130°C or more, more preferably 140°C or more, and further preferably 150°C or more, and from the viewpoint of ease of thermoforming, is preferably 250°C or less, more preferably 230°C or less, and further preferably 200°C or less, from the viewpoint of producing a member that has undergone high-precision microfabrication.

The glass transition temperature of the component (a1) can be measured using a differential scanning calorimeter, and specifically by the method described in the examples.

### (Amorphous thermoplastic resin (a2))

The amorphous thermoplastic resin (a2) (hereinafter also simply referred to as "component (a2)") used as component (A) is an amorphous thermoplastic resin having a glass transition temperature of 200°C or more from the viewpoint of producing a member that has undergone high-precision microfabrication.

The glass transition temperature (Tg) of the component (a2) is preferably 210°C or more, more preferably 230°C or more, and further preferably 250°C or more, from the viewpoint of producing a member that has undergone high-precision microfabrication. Further, the glass transition temperature is preferably 400°C or less, more preferably 350°C or less, and further preferably 300°C or less, from the viewpoint of ease of thermoforming.

The glass transition temperature of the component (a2) can be measured by the same method as described above.

Examples of the component (A) include thermoplastic resins that fall under either of the component (a1) or component (a2) among a polyimide resin, a polyamide resin, a polyetherimide resin, a polyetherimide sulfone resin, a polyphenylene sulfide resin, a polyether ether ketone resin, a polyether ketone ketone resin, a polycarbonate resin, a polyamideimide resin, a polysulfone resin, a polyether sulfone resin, a polyarylate resin, a liquid crystal polymer, a wholly aromatic polyester resin other than a liquid crystal polymer, a polyether ketone resin, a polyether ether ketone ketone resin, a polybenzimidazole resin, and a polyphenylene ether resin.

Among the above, from the viewpoint of producing a member that has undergone high-precision microfabrication, the component (A) preferably contains at least one selected from the group consisting of a polyimide resin, a polyetherimide resin, a polyetherimide sulfone resin, a polyphenylene sulfide resin, a polyether ether ketone resin, a polyether ketone ketone resin, a liquid crystal polymer, and a wholly aromatic polyester resin other than a liquid crystal polymer, and more preferably at least one selected from the group consisting of a polyimide resin, a polyetherimide resin, a polyphenylene sulfide resin, and a polyether ether ketone resin. When low dielectric properties are required for the member, the component (A) is more preferably a polyimide resin, and among those a polyimide resin having an aliphatic structure (other than wholly aromatic) or a polyimide resin having a bulky structure such as a halogen.

For the component (A), the component (a1), the component (a2), or a mixture of the component (a1) and the component (a2) can be used.

Using a thermoplastic resin having a high melting point and/or glass transition temperature as the component (A) is preferred because dimensional changes of the member in the high-temperature region can be suppressed. In particular, when the component (A) contains the crystalline thermoplastic resin (a1), a reinforcing effect gained by combining the component (A) and the component (B) is enhanced, and dimensional changes of the resulting member in the high-temperature region can be further suppressed. For example, it is possible to make the linear expansion coefficient of the member at a temperature of 25 to 200°C 100 ppm/K or less, and by increasing the amount of the crystalline thermoplastic resin (a1) or by using an additive that shrinks at high temperatures, it is also possible to make the linear expansion coefficient of the member at a temperature of 25 to 200°C several tens of ppm/K to several ppm/K. In addition, since the crystalline thermoplastic resin (a1) can suppress water absorption, the crystalline thermoplastic resin (a1) can also suppress dimensional changes of the member due to moisture absorption. For example, it is possible to make the moisture absorption expansion coefficient of the member 20 ppm/% RH or less.

From the viewpoint of producing a member that has undergone high-precision microfabrication, the component (A) preferably contains the component (a1), which is a crystalline thermoplastic resin.

The content of the component (a1) in the component (A) is preferably 50% by mass or more, more preferably 60% by mass or more, further preferably 70% by mass or more, still further preferably 80% by mass or more, and still further preferably 90% by mass or more, and is 100% by mass or less, from the viewpoint of producing a member that has undergone high-precision microfabrication.

When the component (A) contains the component (a1), from the viewpoint of producing a member that has undergone high-precision microfabrication and the viewpoint of ease of thermoforming, the component (a1) more preferably includes a polyimide resin, and is more preferably a polyimide resin (a1-1) containing a repeating structural unit represented by the following formula (1) and a repeating structural unit represented by the following formula (2), a content ratio of the repeating structural unit of formula (1) to the total of the repeating structural unit of formula (1) and the repeating structural unit of formula (2) being 20 to 70 mol%.

The content of the polyimide resin (a1-1) in component (a1) is, from the viewpoint of producing a member that has undergone to high-precision microfabrication, preferably 50% by mass or more, more preferably 60% by mass or more, further preferably 70% by mass or more, still further preferably 80% by mass or more, and still further preferably 90% by mass or more, and is 100% by mass or less. 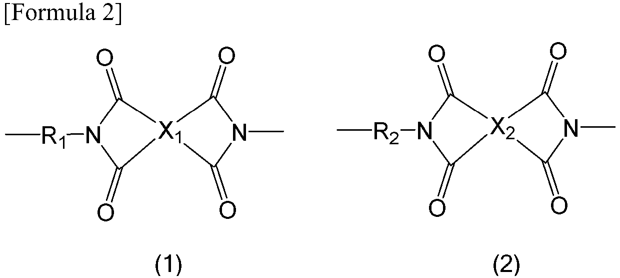 wherein R₁ represents a divalent group having from 6 to 22 carbon atoms containing at least one alicyclic hydrocarbon structure; R₂ represents a divalent chain aliphatic group having from 5 to 16 carbon atoms; and X₁ and X₂ each independently represent a tetravalent group having from 6 to 22 carbon atoms containing at least one aromatic ring.

The polyimide resin (a1-1) is a crystalline thermoplastic resin, which is preferably in a powder or pellet form. The polyimide resin is distinguished from, for example, polyimide resins formed by closing the imide ring after shaping in a state of a polyimide precursor such as a polyamic acid and having no glass transition temperature (Tg), or polyimide resins that decompose at a temperature lower than the glass transition temperature.

When producing the member of the present invention, and in particular when the molded article is laser processed to form fine through-holes, the thermoplastic resin composition and the molded article produced therefrom need to be compatible with laser processing. According to investigations by the inventors, the inventors found that being compatible with laser processes is not necessarily the same as being compatible with machining processes. For example, the higher the melting point or glass transition temperature of the thermoplastic resin (A), the better the compatibility with laser processing. Although the reason for this is not clear, it is presumed that when the polyimide resin (a1-1) is used as the thermoplastic resin (A), a heat resistance balance against the laser can be secured, facilitating the melting and evaporation of the thermoplastic resin composition in the laser irradiated area, which prevents the occurrence of burrs and residue of evaporated material, while also fully ensuring heat resistance around the laser irradiated area, and so as a result, melting and dimensional changes due to laser irradiation are suppressed. Therefore, it is presumed that the molded article has excellent processing compatibility in the case of forming a plurality of through-holes by a laser processing, and that a member that has undergone high-precision microfabrication can be obtained.

The repeating structural unit of formula (1) will be described in detail below.

R₁ represents a divalent group having from 6 to 22 carbon atoms containing at least one alicyclic hydrocarbon structure. The alicyclic hydrocarbon structure herein means a ring derived from an alicyclic hydrocarbon compound, and the alicyclic hydrocarbon compound may be either saturated or unsaturated and may be either monocyclic or polycyclic.

Examples of the alicyclic hydrocarbon structure include a cycloalkane ring, such as a cyclohexane ring, a cycloalkene ring, such as cyclohexene, a bicycloalkane ring, such as a norbornane ring, and a bicycloalkene ring, such as norbomene, but the alicyclic hydrocarbon structure is not limited thereto. Among these, a cycloalkane ring is preferred, a cycloalkane ring having from 4 to 7 carbon atoms is more preferred, and a cyclohexane ring is further preferred.

R₁ has from 6 to 22 carbon atoms, and preferably from 8 to 17 carbon atoms.

R₁ contains at least one alicyclic hydrocarbon structure, and preferably from 1 to 3 alicyclic hydrocarbon structures.

R₁ is preferably a divalent group represented by the following formula (R1-1) or (R1-2): 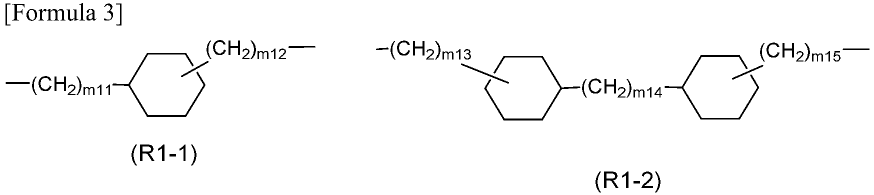 wherein m₁₁ and m₁₂ each independently represent an integer of 0-2, and preferably 0 or 1; and m₁₃ to m₁₅ each independently represent an integer of 0-2, and preferably 0 or 1.

R₁ is particularly preferably a divalent group represented by the following formula (R1-3):

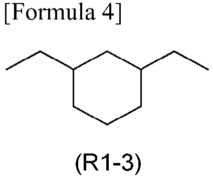

In the divalent group represented by the formula (R1-3), the conformation of the two methylene groups with respect to the cyclohexane ring may be either cis or trans, and the ratio of cis and trans may be an arbitrary value.

X₁ is a tetravalent group having from 6 to 22 carbon atoms containing at least one aromatic ring. The aromatic ring may be either a monocyclic ring or a condensed ring, and examples thereof include a benzene ring, a naphthalene ring, an anthracene ring and a tetracene ring, but the aromatic ring is not limited thereto. Among these, a benzene ring and a naphthalene ring are preferred, and a benzene ring is more preferred.

X₁ has from 6 to 22 carbon atoms, and preferably has from 6 to 18 carbon atoms.

X₁ contains at least one aromatic ring, and preferably contains from 1 to 3 aromatic rings.

X₁ is preferably a tetravalent group represented by one of the following formulae (X-1) to (X-4): 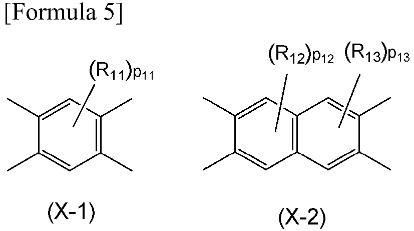 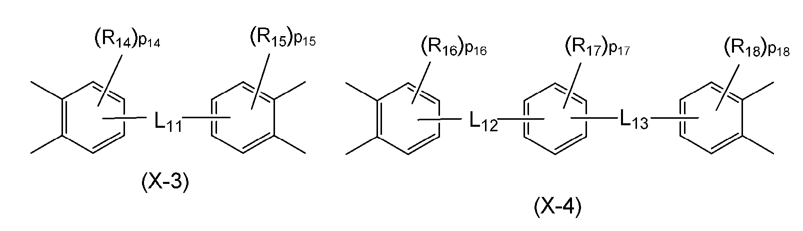 wherein R₁₁ to R₁₈ each independently represent an alkyl group having from 1 to 4 carbon atoms; p₁₁ to p₁₃ each independently represent an integer of 0-2, and preferably 0; p₁₄, p₁₅, p₁₆ and p₁₈ each independently represent an integer of 0-3, and preferably 0; p₁₇ represents an integer of 0-4, and preferably 0; and L₁₁ to L₁₃ each independently represent a single bond, an ether group, a carbonyl group or an alkylene group having from 1 to 4 carbon atoms.

X₁ is a tetravalent group having from 6 to 22 carbon atoms containing at least one aromatic ring, and therefore R₁₂, R₁₃, p₁₂ and p₁₃ in the formula (X-2) are selected in such a manner that the tetravalent group represented by the formula (X-2) has from 10 to 22 carbon atoms.

Similarly, L₁₁, R₁₄, R₁₅, p₁₄ and p₁₅ in the formula (X-3) are selected in such a manner that the tetravalent group represented by the formula (X-3) has from 12 to 22 carbon atoms, and L₁₂, L₁₃, R₁₆, R₁₇, R₁₈, p₁₆, p₁₇ and p₁₈ in the formula (X-4) are selected in such a manner that the tetravalent group represented by the formula (X-4) has from 18 to 22 carbon atoms.

X₁ is particularly preferably a tetravalent group represented by the following formula (X-5) or (X-6):

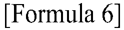

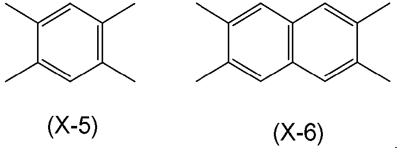

Next, the repeating structural unit of formula (2) will be described in detail below.

R₂ represents a divalent chain aliphatic group having from 5 to 16 carbon atoms, preferably from 6 to 14 carbon atoms, more preferably from 7 to 12 carbon atoms, and further preferably from 8 to 10 carbon atoms. The chain aliphatic group herein means a group derived from a chain aliphatic compound, and the chain aliphatic compound may be either saturated or unsaturated, may be in the form of either linear or branched chain, and may contain a hetero atom, such as an oxygen atom.

R₂ is preferably an alkylene group having from 5 to 16 carbon atoms, more preferably an alkylene group having from 6 to 14 carbon atoms, further preferably an alkylene group having from 7 to 12 carbon atoms, and particularly preferably an alkylene group having from 8 to 10 carbon atoms. The alkylene group may be either a linear alkylene group or a branched alkylene group, and is preferably a linear alkylene group.

R₂ preferably represents at least one selected from the group consisting of an octamethylene group and a decamethylene group, and more preferably represents an octamethylene group.

Another preferred embodiment of R₂ is a divalent chain aliphatic group having from 5 to 16 carbon atoms containing an ether group. The divalent chain aliphatic group preferably has from 6 to 14 carbon atoms, more preferably from 7 to 12 carbon atoms, and further preferably from 8 to 10 carbon atoms. Preferred examples of the group include a divalent group represented by the following formula (R2-1) or (R2-2):
[Formula 7]

(R2-1) -(CH₂)ₘ₂₁-O-(CH₂)ₘ₂₂-

(R2-2) -(CH₂)ₘ₂₃-O-(CH₂)ₘ₂₄-O-(CH₂)ₘ₂₅-

wherein m₂₁ and m₂₂ each independently represent an integer of 1-15, preferably 1-13, more preferably 1-11, and further preferably 1-9; and m₂₃ to m₂₅ each independently represent an integer of 1-14, preferably 1-12, more preferably 1-10, and further preferably 1-8.

R₂ represents a divalent chain aliphatic group having from 5 to 16 carbon atoms (preferably from 6 to 14 carbon atoms, more preferably from 7 to 12 carbon atoms, and further preferably from 8 to 10 carbon atoms), and therefore m₂₁ and m₂₂ in the formula (R2-1) are selected so that the divalent group represented by the formula (R2-1) has from 5 to 16 carbon atoms (preferably from 6 to 14 carbon atoms, more preferably from 7 to 12 carbon atoms, and further preferably from 8 to 10 carbon atoms), i.e., m₂₁ + m₂₂ is from 5 to 16 (preferably 6 to 14, more preferably 7 to 12, and further preferably 8 to 10).

Similarly, m₂₃ to m₂₅ in the formula (R2-2) are selected so that the divalent group represented by the formula (R2-2) has from 5 to 16 carbon atoms (preferably from 6 to 14 carbon atoms, more preferably from 7 to 12 carbon atoms, and further preferably from 8 to 10 carbon atoms), i.e., m₂₃ + m₂₄ + m₂₅ is from 5 to 16 (preferably from 6 to 14 carbon atoms, more preferably from 7 to 12 carbon atoms, and further preferably from 8 to 10 carbon atoms).

X₂ is defined similarly to X₁ in the formula (1), and preferred embodiments thereof are also the same.

The content ratio of the repeating structural unit of the formula (1) with respect to the total of the repeating structural unit of the formula (1) and the repeating structural unit of the formula (2) is 20 mol% to 70 mol%. In the case where the content ratio of the repeating structural unit of formula (1) is in the above range, the polyimide resin (a1-1) may also be sufficiently crystallized in an ordinary injection molding cycle. When the content ratio is less than 20 mol%, thermoformability deteriorates, and when the content ratio is more than 70 mol%, crystallinity deteriorates, resulting in a deterioration in heat resistance.

The content ratio of the repeating structural unit of the formula (1) with respect to the total of the repeating structural unit of the formula (1) and the repeating structural unit of the formula (2) is preferably 65 mol% or less, more preferably 60 mol% or less, further preferably 50 mol% or less, still further preferably 45 mol% or less, and still further preferably 42 mol% or less from the viewpoint of exerting high crystallinity.

Among these, the content ratio of the repeating structural unit of the formula (1) with respect to the total of the repeating structural unit of the formula (1) and the repeating structural unit of the formula (2) is preferably 20 mol% or more and less than 40 mol%. When the ratio falls within this range, the crystallinity of the polyimide resin (a1-1) increases, and it is possible to obtain a resin composition being more excellent in heat resistance.

The content ratio described above is preferably 25 mol% or more, more preferably 28 mol% or more, further preferably 30 mol% or more, and still further preferably 32 mol% or more from the viewpoint of producing a member that has undergone high-precision microfabrication, and still further preferably 38 mol% or less, still further preferably 36 mol% or less, and still further preferably 35 mol% or less from the viewpoint of exerting high crystallinity.

The content ratio of the total of the repeating structural unit of the formula (1) and the repeating structural unit of the formula (2) with respect to the total repeating structural units constituting the polyimide resin (a1-1) is preferably 50 to 100 mol%, more preferably 75 to 100 mol%, further preferably 80 to 100 mol%, and still further preferably 85 to 100 mol%.

The polyimide resin (a1-1) may further contain a repeating structural unit represented by the following formula (3). In this case, the content ratio of the repeating structural unit of formula (3) with respect to the total of the repeating structural unit of formula (1) and the repeating structural unit of formula (2) is preferably 25 mol% or less. The lower limit thereof is not particularly limited but needs to exceed 0 mol%.

The content ratio is preferably 5 mol% or more, and more preferably 10 mol% or more, from the viewpoint of enhancement of the heat resistance, and is preferably 20 mol% or less, and more preferably 15 mol% or less, from the viewpoint of maintenance of the crystallinity. 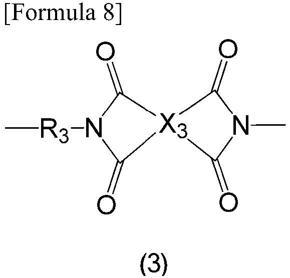 wherein R₃ represents a divalent group having from 6 to 22 carbon atoms containing at least one aromatic ring; and X₃ represents a tetravalent group having from 6 to 22 carbon atoms containing at least one aromatic ring.

R₃ is a divalent group having from 6 to 22 carbon atoms containing at least one aromatic ring. The aromatic ring may be either a monocyclic ring or a condensed ring, and examples thereof include a benzene ring, a naphthalene ring, an anthracene ring and a tetracene ring, but the aromatic ring is not limited thereto. Among these, a benzene ring and a naphthalene ring are preferred, and a benzene ring is more preferred.

R₃ has from 6 to 22 carbon atoms, and preferably has from 6 to 18 carbon atoms.

R₃ contains at least one aromatic ring, and preferably contains from 1 to 3 aromatic rings.

The aromatic ring may also be bonded to a monovalent or divalent electron-attracting group. Examples of the monovalent electron-attracting group include a nitro group, a cyano group, a p-toluenesulfonyl group, halogen, an alkyl halide group, a phenyl group, and an acyl group. Examples of the divalent electron-attracting group include alkylene halide groups such as alkylene fluoride groups (e.g., -C (CF₃)₂- and -(CF₂)ₚ- (wherein p is an integer of 1-10)), as well as -CO-, -SO₂-, -SO-, -CONH-, and -COO-.

R₃ is preferably a divalent group represented by the following formula (R3-1) or (R3-2): 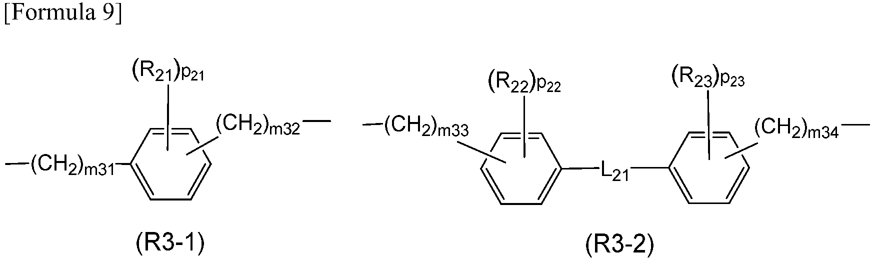 wherein m₃₁ and m₃₂ each independently represent an integer of 0-2, and preferably 0 or 1; m₃₃ and m₃₄ each independently represent an integer of 0-2, and preferably 0 or 1; R₂₁, R₂₂ and R₂₃ each independently represent an alkyl group having from 1 to 4 carbon atoms, an alkenyl group having from 2 to 4 carbon atoms or an alkynyl group having from 2 to 4 carbon atoms; p₂₁, p₂₂ and p₂₃ each represent an integer of 0-4, and preferably 0; and L₂₁ represents a single bond, an ether group, a carbonyl group or an alkylene group having from 1 to 4 carbon atoms.

R₃ is a divalent group having from 6 to 22 carbon atoms containing at least one aromatic ring, and therefore m₃₁, m₃₂, R₂₁ and p₂₁ in the formula (R3-1) are selected in such a manner that the divalent group represented by the formula (R3-1) has from 6 to 22 carbon atoms.

Similarly, L₂₁, m₃₃, m₃₄, R₂₂, R₂₃, p₂₂ and p₂₃ in the formula (R3-2) are selected in such a manner that the divalent group represented by the formula (R3-2) has from 12 to 22 carbon atoms.

X₃ is defined similarly to X₁ in the formula (1), and preferred embodiments thereof are also the same.

The polyimide resin (a1-1) may further contain a repeating structural unit represented by the following formula (4): 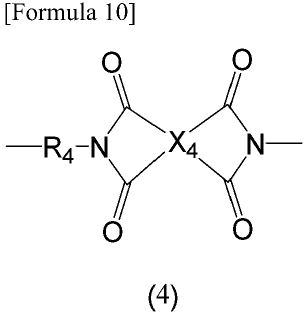 wherein R₄ represents a divalent group containing -SO₂- or -Si(Rₓ)(R_{y})O-; Rₓ and R_{y} each independently represent a chain aliphatic group having from 1 to 3 carbon atoms, or a phenyl group; and X₄ represents a tetravalent group having from 6 to 22 carbon atoms containing at least one aromatic ring.

X₄ is defined similarly to X₁ in the formula (1), and preferred embodiments thereof are also the same.

The end structure of the polyimide resin (a1-1) is not particularly limited, and preferably has a chain aliphatic group having 5 to 14 carbon atoms at the end thereof.

The chain aliphatic group may be either saturated or unsaturated, and may be in the form of either linear or branched chain. When the polyimide resin (a1-1) contains the above particular group at the end thereof, it is possible to obtain a resin composition excellent in heat aging resistance.

Example of the saturated chain aliphatic group having from 5 to 14 carbon atoms include an n-pentyl group, an n-hexyl group, an n-heptyl group, an n-octyl group, an n-nonyl group, an n-decyl group, an n-undecyl group, a lauryl group, an n-tridecyl group, an n-tetradecyl group, an isopentyl group, a neopentyl group, a 2-methylpentyl group, a 2-methylhexyl group, a 2-ethylpentyl group, a 3-ethylpentyl group, an isooctyl group, a 2-ethylhexyl group, a 3-ethylhexyl group, an isononyl group, a 2-ethyloctyl group, an isodecyl group, an isododecyl group, an isotridecyl group and an isotetradecyl group.

Example of the unsaturated chain aliphatic group having from 5 to 14 carbon atoms include a 1-pentenyl group, a 2-pentenyl group, a 1-hexenyl group, a 2-hexenyl group, a 1-heptenyl group, a 2-heptenyl group, a 1-octenyl group, a 2-octenyl group, a nonenyl group, a decenyl group, a dodecenyl group, a tridecenyl group and a tetradecenyl group.

Among these, the chain aliphatic group is preferably a saturated chain aliphatic group, and more preferably a saturated linear aliphatic group. The chain aliphatic group preferably has 6 or more carbon atoms, more preferably 7 or more carbon atoms and further preferably 8 or more carbon atoms, and preferably has 12 or less carbon atoms, more preferably 10 or less carbon atoms and further preferably 9 or less carbon atoms from the viewpoint of achievement of heat aging resistance. The chain aliphatic group may be adopted singly or in combinations of two or more.

The chain aliphatic group is particularly preferably at least one selected from the group consisting of an n-octyl group, an isooctyl group, a 2-ethylhexyl group, an n-nonyl group, an isononyl group, an n-decyl group and an isodecyl group, further preferably at least one selected from the group consisting of an n-octyl group, an isooctyl group, a 2-ethylhexyl group, an n-nonyl group, and an isononyl group, and most preferably at least one selected from the group consisting of an n-octyl group, an isooctyl group, and a 2-ethylhexyl group.

The polyimide resin (a1-1) preferably contains only a chain aliphatic group having from 5 to 14 carbon atoms, besides a terminal amino group and a terminal carboxy group, at the end thereof from the viewpoint of heat aging resistance. When a group, besides the above groups, is contained at the end, the content thereof with respect to the chain aliphatic group having from 5 to 14 carbon atoms is preferably 10 mol% or less and more preferably 5 mol% or less.

The content of the chain aliphatic group having from 5 to 14 carbon atoms in the polyimide resin (a1-1) is preferably 0.01 mol% or more, more preferably 0.1 mol% or more, and further preferably 0.2 mol% or more based on the total 100 mol% of the total repeating structural units constituting the polyimide resin (a1-1) from the viewpoint of exerting excellent heat aging resistance. In order that a sufficient molecular weight is ensured and good mechanical properties are achieved, the content of the chain aliphatic group having from 5 to 14 carbon atoms in the polyimide resin (a1-1) is preferably 10 mol% or less, more preferably 6 mol% or less and further preferably 3.5 mol% or less based on the total 100 mol% of the total repeating structural units constituting the polyimide resin (a1-1).

The "total of the total repeating structural units constituting the polyimide resin (a1-1)" referred to here means the total of the repeating structural units represented by the formulas (1), (2), (3), and (4).

The content of the chain aliphatic group having from 5 to 14 carbon atoms in the polyimide resin (a1-1) can be determined by depolymerization of the polyimide resin (a1-1).

The polyimide resin (a1-1) preferably has a melting point of 360°C or less and a glass transition temperature of 150°C or more. The melting point of the polyimide resin (a1-1) is more preferably 280°C or more and further preferably 290°C or more from the viewpoint of producing a member that has undergone high-precision microfabrication, and is preferably 345°C or less, more preferably 340°C or less, and further preferably 335°C or less from the viewpoint of ease of thermoforming. In addition, the glass transition temperature of the polyimide resin (a1-1) is more preferably 160°C or more and more preferably 170°C or more from the viewpoint of producing a member that has undergone high-precision microfabrication, and is preferably 250°C or less, more preferably 230°C or less, and further preferably 200°C or less from the viewpoint of ease of thermoforming.

A crystallization temperature Tc of the polyimide resin (a1-1) is preferably 200°C or more, more preferably 220°C or more, and further preferably 250°C or more from the viewpoint of heat resistance, and is preferably 350°C or less, more preferably 320°C or less, and further preferably 300°C or less from the viewpoint of molding processability.

From the viewpoint of improving crystallinity, heat resistance, mechanical strength, and chemical resistance, the polyimide resin (a1-1) preferably has a heat of melting Hm of 5.0 mJ/mg or more, more preferably 10 mJ/mg or more, and further preferably 17 mJ/mg or more. The upper limit of the heat of melting Hm is not particularly limited, and is usually 45 mJ/mg or less.

The heat of melting Hm of the polyimide resin (a1-1) is calculated by differential scanning calorimetry from the area of the heat of melting peak (endothermic peak) observed near the melting point when the polyimide resin (a1-1) is heated at a heating rate of 10 °C/min to melt at a temperature equal to or more than the melting point, then cooled at a cooling rate of 20 °C/min, and then heated again at a heating rate of 10 °C/min to melt the polyimide resin (a1-1).

Further, from the viewpoint of improving crystallinity, heat resistance, mechanical strength, and chemical resistance, the polyimide resin (a1-1) preferably has a heat of crystallization Hc of 5.0 mJ/mg or more, more preferably 10 mJ/mg or more, and further preferably 17 mJ/mg or more. The upper limit of the heat of crystallization Hc is not particularly limited, and is usually 45 mJ/mg or less.

The heat of crystallization Hc of the polyimide resin (a1-1) means the exothermic amount of the crystallization exothermic peak observed in melting and then cooling of the polyimide resin (a1-1) at a cooling rate of 20°C/min with differential scanning calorimetric measurement.

Specifically, the melting point Tm, glass transition temperature Tg, crystallization temperature Tc, heat of melting Hm, and heat of crystallization Hc of the polyimide resin (a1-1) can be measured by the methods described in the Examples.

The logarithmic viscosity of the polyimide resin (a1-1) at 30°C in a 0.5 mass% concentrated sulfuric acid solution is preferably 0.2 to 2.0 dL/g and more preferably 0.3 to 1.8 dL/g. When the logarithmic viscosity is 0.2 dL/g or more, a molded article and a member obtained have sufficient mechanical strength, and when the logarithmic viscosity is 2.0 dL/g or less, thermoformability and handleability are good. The logarithmic viscosity µ is obtained according to the following expression by measuring the elapsed times for flowing concentrated sulfuric acid and the polyimide resin solution at 30°C with a Cannon-Fenske viscometer.$μ = ln \left(ts/{t}_{0}\right) / C$
t₀: elapsed time for flowing concentrated sulfuric acid
ts: elapsed time for flowing polyimide resin solution
C: 0.5 (g/dL)

The weight average molecular weight Mw of the polyimide resin (A) is preferably in the range of 10,000 to 150,000, more preferably 15,000 to 100,000, further preferably 20,000 to 80,000, still further preferably 30,000 to 70,000, and still further preferably 35,000 to 65,000. When the weight average molecular weight Mw of the polyimide resin (a1-1) is 10,000 or more, the mechanical strength of the molded article and the member obtained is good, and when it is 40,000 or more, the stability of the mechanical strength is good. When the weight average molecular weight Mw is 150,000 or less, thermoformability is good.

The weight average molecular weight Mw of the polyimide resin (a1-1) can be measured by a gel permeation chromatography (GPC) method using polymethyl methacrylate (PMMA) as a standard sample.

### (Method for producing polyimide resin (a1-1))

The polyimide resin (a1-1) may be produced by reacting a tetracarboxylic acid component and a diamine component. The tetracarboxylic acid component contains a tetracarboxylic acid containing at least one aromatic ring and/or a derivative thereof, and the diamine component contains a diamine containing at least one alicyclic hydrocarbon structure and a chain aliphatic diamine.

The tetracarboxylic acid containing at least one aromatic ring is preferably a compound having four carboxy groups that are bonded directly to the aromatic ring, and may contain an alkyl group in the structure thereof. The tetracarboxylic acid preferably has from 6 to 26 carbon atoms. The tetracarboxylic acid preferably contains at least one selected from the group consisting of pyromellitic acid, 2,3,5,6-toluenetetracarboxylic acid, 3,3',4,4'-benzophenonetetracarboxylic acid, 3,3',4,4'-biphenyltetracarboxylic acid and 1,4,5,8-naphthalenetetracarboxylic acid. Among these, it is more preferred to contain pyromellitic acid.

Examples of the derivative of the tetracarboxylic acid containing at least one aromatic ring include an anhydride and an alkyl ester compound of a tetracarboxylic acid containing at least one aromatic ring. The derivative of the tetracarboxylic acid preferably has from 6 to 38 carbon atoms. Examples of the anhydride of the tetracarboxylic acid include pyromellitic monoanhydride, pyromellitic dianhydride, 2,3,5,6-toluenetetracarboxylic dianhydride, 3,3',4,4'-diphenylsulfonetetracarboxylic dianhydride, 3,3',4,4'-benzophenonetetracarboxylic dianhydride, 3,3',4,4'-biphenyltetracarboxylic dianhydride and 1,4,5,8-naphthalenetetracarboxylic dianhydride. Examples of the alkyl ester compound of the tetracarboxylic acid include dimethyl pyromellitate, diethyl pyromellitate, dipropyl pyromellitate, diisopropyl pyromellitate, dimethyl 2,3,5,6-toluenetetracarboxylate, dimethyl 3,3',4,4'-diphenylsulfonetetracarboxylate, dimethyl 3,3',4,4'-benzophenonetetracarboxylate, dimethyl 3,3',4,4'-biphenyltetracarboxylate and dimethyl 1,4,5,8-naphthalenetetracarboxylate. The alkyl group in the alkyl ester compound of the tetracarboxylic acid preferably has from 1 to 3 carbon atoms.

The tetracarboxylic acid containing at least one aromatic ring and/or the derivative thereof may be used as a sole compound selected from the aforementioned compounds or may be used as a combination of two or more compounds.

The diamine containing at least one alicyclic hydrocarbon structure preferably has from 6 to 22 carbon atoms, and preferred examples thereof include at least one selected from the group consisting of 1,2-bis(aminomethyl)cyclohexane, 1,3-bis(aminomethyl)cyclohexane, 1,4-bis(aminomethyl)cyclohexane, 1,2-cyclohexanediamine, 1,3-cyclohexanediamine, 1,4-cyclohexanediamine, 4,4'-diaminodicyclohexylmethane, 4,4'-methylenebis(2-methylcyclohexylamine), carvone diamine, limonene diamine, isophorone diamine, norbornane diamine, bis(aminomethyl)tricyclo[5.2.1.0^{2,6}]decane, 3,3'-dimethyl-4,4'-diaminodicyclohexylmethane and 4,4'-diaminodicyclohexylpropane. These compounds may be used solely or may be used as a combination of two or more compounds selected therefrom. Among these, 1,3-bis(aminomethyl)cyclohexane is preferably used. A diamine containing an alicyclic hydrocarbon structure generally has conformational isomers, and the ratio of the cis isomer and the trans isomer is not particularly limited.

The chain aliphatic diamine may be in the form of either linear or branched chain, and has preferably from 5 to 16 carbon atoms, more preferably from 6 to 14 carbon atoms and further preferably from 7 to 12 carbon atoms. The linear moiety having from 5 to 16 carbon atoms may contain an ether bond in the course thereof. Preferred examples of the chain aliphatic diamine include at least one selected from the group consisting of 1,5-pentamethylenediamine, 2-methylpentane-1,5-diamine, 3-methylpentane-1,5-diamine, 1,6-hexamethylenediamine, 1,7-heptamethylenediamine, 1,8-octamethylenediamine, 1,9-nonamethylenediamine, 1,10-decamethylenediamine, 1,11-undecamethylenediamine, 1,12-dodecamethylenediamine, 1,13-tridecamethylenediamine, 1,14-tetradecamethylenediamine, 1,16-hexadecamethylenediamine, and 2,2'-(ethylenedioxy)bis(ethyleneamine).

The chain aliphatic diamine may be used as a sole compound or as a mixture of plural kinds thereof. Among these, a chain aliphatic diamine having from 8 to 10 carbon atoms can be preferably used, and at least one selected from the group consisting of 1,8-octamethylenediamine and 1,10-decamethylenediamine can be particularly preferably used.

In the production of the polyimide resin (a1-1), the molar ratio of the charged amount of the diamine containing at least one alicyclic hydrocarbon structure with respect to the total amount of the diamine containing at least one alicyclic hydrocarbon structure and the chain aliphatic diamine is preferably 20 to 70 mol%. The molar ratio is preferably 25 mol% or more, more preferably 30 mol% or more, and further preferably 32 mol% or more, and from the viewpoint of exerting high crystallinity, is preferably 60 mol% or less, more preferably 50 mol% or less, further preferably 45 mol% or less, still further preferably 42 mol% or less, still further preferably less than 40 mol%, still further preferably 38 mol% or less, still further preferably 36 mol% or less, and still further preferably 35 mol% or less.

The diamine component may contain a diamine containing at least one aromatic ring. The diamine containing at least one aromatic ring preferably has from 6 to 22 carbon atoms, and examples thereof include o-xylylenediamine, m-xylylenediamine, p-xylylenediamine, 1,2-diethynylbenzenediamine, 1,3-diethynylbenzenediamine, 1,4-diethynylbenzenediamine, 1,2-diaminobenzene, 1,3-diaminobenzene, 1,4-diaminobenzene, 4,4'-diaminodiphenyl ether, 3,4'-diaminodiphenyl ether, 4,4'-diaminodiphenylmethane, α,α'-bis(4-aminophenyl)-1,4-diisopropylbenzene, α,α'-bis(3-aminophenyl)-1,4-diisopropylbenzene, 2,2-bis(4-(4-aminophenoxy)phenyl)propane, 2,6-diaminonaphthalene and 1,5-diaminonaphthalene.

The molar ratio of the charged amount of the diamine containing at least one aromatic ring with respect to the total amount of the diamine containing at least one alicyclic hydrocarbon structure and the chain aliphatic diamine is preferably 25 mol% or less. The lower limit thereof is not particularly limited but needs to exceed 0 mol%.

The molar ratio is preferably 5 mol% or more, and more preferably 10 mol% or more, from the viewpoint of enhancement of the heat resistance, and is preferably 20 mol% or less, and more preferably 15 mol% or less, from the viewpoint of maintenance of the crystallinity.

In addition, the molar ratio is preferably 12 mol% or less, more preferably 10 mol% or less, further preferably 5 mol% or less and still more preferably 0 mol% from the viewpoint of a decrease in coloration of the polyimide resin (a1-1).

In the production of the polyimide resin (a1-1), the charged amount ratio of the tetracarboxylic acid component and the diamine component is preferably from 0.9 to 1.1 mol of the diamine component per 1 mol of the tetracarboxylic acid component.

In the production of the polyimide resin (a1-1), an end capping agent may be mixed in addition to the tetracarboxylic acid component and the diamine component. The end capping agent is preferably at least one selected from the group consisting of a monoamine compound and a dicarboxylic acid compound. The amount of the end capping agent to be used may be any amount as long as a desired amount of an end group can be introduced into the polyimide resin (a1-1), and the amount is preferably 0.0001 to 0.1 mol, more preferably 0.001 to 0.06 mol, and further preferably 0.002 to 0.035 mol, per 1 mol of the tetracarboxylic acid and/or the derivative thereof.

Among them, monoamine end capping agents are preferable as the end capping agent, and from the viewpoint of introducing the above-described chain aliphatic group having 5 to 14 carbon atoms at an end of the polyimide resin (a1-1) to improve heat aging resistance, a monoamine that has a chain aliphatic group having 5 to 14 carbon atoms is more preferable, and a monoamine that has a saturated linear aliphatic group having 5 to 14 carbon atoms is further preferable.

The end capping agent is particularly preferably at least one selected from the group consisting of n-octylamine, isooctylamine, 2-ethylhexylamine, n-nonylamine, isononylamine, n-decylamine, and isodecylamine, further preferably at least one selected from the group consisting of n-octylamine, isooctylamine, 2-ethylhexylamine, n-nonylamine, and isononylamine, and still more preferably at least one selected from the group consisting of n-octylamine, isooctylamine, and 2-ethylhexylamine.

As a polymerization method for producing the polyimide resin (a1-1), a known polymerization method may be applied, and the method described in WO 2016/147996 can be used.

The content of the polyimide resin (a1-1) in the component (A) is, from the viewpoint of producing a member that has undergone high-precision microfabrication and the viewpoint of ease of thermoforming, preferably 30% by mass or more, more preferably 50% by mass or more, further preferably 60% by mass or more, still further preferably 70% by mass or more, still further preferably 80% by mass or more, and still further preferably 90% by mass or more, and is 100% by mass or less.

The content of the component (A) in the thermoplastic resin composition is preferably 40% by mass or more, more preferably 50% by mass or more, further preferably 60% by mass or more, still further preferably 65% by mass or more, and still further preferably 70% by mass or more, from the viewpoint of producing a member that has undergone high-precision microfabrication and the viewpoint of ease of thermoforming. Further, the content is preferably 95% by mass or less, more preferably 90% by mass or less, further preferably 85% by mass or less, and still further preferably 80% by mass or less, from the viewpoint of producing a member that has undergone high-precision microfabrication.

### <Component (B): inorganic filler including zirconium oxide (b1)>

The thermoplastic resin composition used in the present invention contains an inorganic filler including zirconium oxide (b1) as the component (B).

By using the thermoplastic resin (A) and the inorganic filler (B) including a predetermined amount of zirconium oxide (b1), a member that has undergone high-precision microfabrication can be produced.

### (Component (b1): zirconium oxide)

The shape of the zirconium oxide (b1) used in the present invention is not particularly limited, and examples include spherical, plate-like, scale-like, columnar, and fibrous. Among these, spherical or plate-shaped particles are preferable, and spherical particles are more preferable, from the viewpoint of producing a member that has undergone high-precision microfabrication.

The zirconium oxide (b1) preferably has a small particle size from the viewpoint of producing a member that has undergone high-precision microfabrication and from the viewpoint of availability. For example, from the viewpoint of producing a member that has undergone high-precision microfabrication, the component (b1) has a volume median diameter (D50) of preferably 1 µm or less, more preferably 0.80 µm or less, further preferably 0.60 µm or less, still further preferably 0.50 µm or less, and still further preferably 0.40 µm or less. Further, from the viewpoint of producing a member that has undergone high-precision microfabrication, availability, and the viewpoint of improving handleability, the volume median diameter (D50) is usually 0.01 µm or more, more preferably 0.02 µm or more, and further preferably 0.05 µm or more.

The D50 of the component (b1) can be measured using a laser diffraction light scattering particle size distribution measuring instrument.

Examples of commercially available zirconium oxide particles used as the component (b1) include the KZ series manufactured by KCM Corporation, the TZ series manufactured by Tosoh Corporation, the UEP series manufactured by Daiichi Kigenso-Kagaku Kogyo Co., Ltd., and the like. Among these, the KZ series high purity zirconia "KZ-0Y-LSF" manufactured by KCM Corporation can be suitably selected.

The content of the component (b1) in component (B) is, preferably 20% by mass or more, more preferably 30% by mass or more, further preferably 35% by mass or more, still further preferably 40% by mass or more, still further preferably 50% by mass or more, and still further preferably 60% by mass or more, and is 100% by mass or less, preferably 90% by mass or less, more preferably 80% by mass or less, and further preferably 70% by mass or less, from the viewpoint of producing a member that has undergone high-precision microfabrication.

The content of the component (b1) with respect to 100 parts by mass of the component (A) in the thermoplastic resin composition is 2 to 40 parts by mass, preferably 5 to 35 parts by mass, more preferably 5 to 30 parts by mass, further preferably 10 to 30 parts by mass, and still further preferably 20 to 30 parts by mass, from the viewpoint of ease of thermoforming and the viewpoint of producing a member that has undergone high-precision microfabrication.

### (Component (b2): inorganic filler other than component (b1))

The component (B) may be an inorganic filler composed only of the component (b1), or may further include an inorganic filler (b2) other than the component (b1).

Examples of the component (b2) include talc, mica, silica, alumina, wollastonite, silicon nitride, aluminum nitride, boron nitride, silicon carbide, boron carbide, calcium carbonate, titanium oxide, zinc oxide, calcium oxide, magnesium carbonate, barium carbonate, magnesium sulfate, barium sulfate, antimony trisulfide, tin sulfide, copper sulfide, iron sulfide, bismuth sulfide, and zinc sulfide. One or more of these can be used.

Among the above, from the viewpoint of producing a member that has undergone high-precision microfabrication, the component (b2) preferably includes at least one selected from the group consisting of talc, mica, silica, alumina, silicon nitride, aluminum nitride, boron nitride, silicon carbide, boron carbide, calcium carbonate, and titanium oxide, more preferably at least one selected from the group consisting of talc, mica, silica, and titanium oxide, further preferably at least one selected from the group consisting of talc and silica, and still further preferably is talc.

The shape of the component (b2) used is also not particularly limited, and examples include spherical, plate-like, scale-like, columnar, and fibrous. Among these, from the viewpoint of producing a member that has undergone high-precision microfabrication, and the viewpoint of availability, spherical or plate-shaped particles are preferable.

From the viewpoint of producing a member that has undergone high-precision microfabrication and from the viewpoint of availability, the component (b2) has a volume median diameter (D50) of preferably 3 µm or less, more preferably 2 µm or less, further preferably 1.5 µm or less, still further preferably 1.2 µm or less, and still further preferably 1 µm or less. Further, from the viewpoint of producing a member that has undergone high-precision microfabrication, availability, and the viewpoint of improving handleability, the volume median diameter (D50) is usually 0.01 µm or more, more preferably 0.05 µm or more, and further preferably 0.1 µm or more.

The D50 of the component (b2) can be measured by the same method as for the component (b1).

When the component (b2) is used, the content of the component (b2) in the component (B) is, from the viewpoint of ease of thermoforming and from the viewpoint of producing a member that has undergone high-precision microfabrication, preferably 80% by mass or less, more preferably 70% by mass or less, further preferably 65% by mass or less, still further preferably 60% by mass or less, still further preferably 50% by mass or less, and still further preferably 40% by mass or less, and is preferably 1% by mass or more, more preferably 5% by mass or more, further preferably 10% by mass or more, still further preferably 15% by mass or more, still further preferably 20% by mass or more, and still further preferably 30% by mass or more.

When the component (b2) is used, the content of the component (b2) with respect to 100 parts by mass of the component (A) in the thermoplastic resin composition is, preferably 1 to 40 parts by mass, more preferably 2 to 30 parts by mass, further preferably 5 to 30 parts by mass, and still further preferably 10 to 20 parts by mass, from the viewpoint of producing a member that has undergone high-precision microfabrication.

The content of the component (B) with respect to 100 parts by mass of the component (A) in the thermoplastic resin composition is, 2 to 60 parts by mass, preferably 5 to 50 parts by mass, more preferably 10 to 45 parts by mass, further preferably 15 to 45 parts by mass, still further preferably 20 to 45 parts by mass, still further preferably 25 to 45 parts by mass, and still further preferably 30 to 45 parts by mass, from the viewpoint of ease of thermoforming and from the viewpoint of producing a member that has undergone high-precision microfabrication.

### <Additive>

In the thermoplastic resin composition, an additive other than the component (B) may be optionally added, such as a reinforcement fiber, a delusterant, a plasticizer, an antistatic agent, an anti-coloring agent, an anti-gelling agent, a colorant, a slidability-improving agent, an antioxidant, a conducting agent, an organic heat-resistant material (thermosetting resin powder), and a resin-modifying agent. In particular, by using graphite, carbon black, graphite, Ketjenblack, or carbon nanotubes as an antistatic agent, a sufficient antistatic effect can be expressed even when added in a small amount that does not impair the properties of the thermoplastic resin composition, and thus such an antistatic agent can be suitably used. In particular, carbon nanotubes are more suitable because a sufficient antistatic effect is exhibited even when a small amount is added, and can suppress deterioration of microfabricability and thermoformability. Examples of commercially available carbon nanotubes include the NTF series manufactured by Koatsu Gas Kogyo Co., Ltd., the K-nanos series manufactured by Kumho Petrochemical, the NC series manufactured by Nanocyl, and the like.

In the case of using an above-described additive, the added amount of the additive is not particularly limited, and is usually 50% by mass or less, preferably 0.0001 to 30% by mass, more preferably 0.001 to 15% by mass, and further preferably 0.01 to 10% by mass, from the viewpoint of exerting the effect of the additive.

Further, a resin other than the thermoplastic resin (A) can be mixed into the thermoplastic resin composition as long as the characteristics of the thermoplastic resin composition are not impaired. When the thermoplastic resin (A) is used in combination with the resin other than the thermoplastic resin (A), the rate of such another resin to be mixed is not particularly limited, as long as the characteristics of the thermoplastic resin composition are not impaired.

However, the total content of the component (A) and the component (B) in the thermoplastic resin composition is preferably 30% by mass or more, more preferably 40% by mass or more, further preferably 50% by mass or more, still further preferably 70% by mass or more, still further preferably 80% by mass or more, and still further preferably 90% by mass or more, and is 100% by mass or less, from the viewpoint of ease of thermoforming and producing a member that has undergone high-precision microfabrication.

Although the thermoplastic resin composition can take any form, it is preferably a pellet.

The thermoplastic resin composition used in the present invention can be obtained as pellets by, for example, adding the thermoplastic resin (A), the inorganic filler (B), and various optional components as necessary into an extruder and dry-blending those components to obtain a mixture, or feeding the inorganic filler (B) and the optional components separately from the location where the thermoplastic resin (A) is fed into the extruder, then melt-kneading the mixture in the extruder, extruding a strand, and cutting the strand into pellets. Further, a molded article described later can be easily produced by introducing the obtained pellets into various molding machines and thermoforming by the method described later.

On the other hand, it is also possible to obtain the molded article without going through the pellet form. For example, the thermoplastic resin (A), the inorganic filler (B), and the various optional components as necessary may be added, the resultant mixture dry blended, then the dry-blended mixture charged into a mold, and compression molded by hot pressing to obtain the molded article directly.

The thermoplastic resin composition used in the present invention preferably does not contain a solvent from the viewpoint of forming into pellets and the viewpoint of performing compression molding. Specifically, a solvent content in the thermoplastic resin composition is preferably 5% by mass or less, more preferably 1% by mass or less, and further preferably 0.1% by mass or less.

The thermoplastic resin composition used in the present invention can also be used for applications other than the member of this invention. Specific examples include gears, bearings, wristwatch housings, semiconductor manufacturing machine jigs, conveyance members, optical connectors, 3D printer members, aerospace members, and the like.

### [Method for producing member]

The present invention further provides a method for producing the member for a probe card or the member for a printed board inspection jig of the present invention, including the following step (I) and step (II) in this order.
Step (I): A step of molding a thermoplastic resin composition by a thermoforming method to obtain a molded article having a plate-like portion, the thermoplastic resin composition containing:
   a component (A) which is at least one thermoplastic resin selected from the group consisting of a crystalline thermoplastic resin (a1) having a melting point of 270°C or more and an amorphous thermoplastic resin (a2) having a glass transition temperature of 200°C or more; and
   a component (B) which is an inorganic filler including a zirconium oxide (b1), wherein
   a content of the component (b1) is 2 to 40 parts by mass with respect to 100 parts by mass of the component (A), and a content of the component (B) is 2 to 60 parts by mass with respect to 100 parts by mass of the component (A).
Step (II): A step of forming a plurality of through-holes in the plate-like portion of the molded article by a machining process or a laser processing.

### <Step (I)>

In step (I), the above-described thermoplastic resin composition is molded by a thermoforming method to obtain a molded article having a plate-like portion.

The thermoplastic resin composition and preferred embodiments thereof are the same as described above.

The molded article obtained in step (I) has a plate-like portion. This is in order to form the through-holes in step (II), described below, that penetrate the plate-like portion of the molded article in the thickness direction. It is sufficient that the molded article having a plate-like portion has at least a portion that has a plate-shape, and such molded article may be a plate-shaped molded article that is entirely plate-like.

The thickness of the plate-like portion depends on the type of member to be produced, but is preferably in the range of 0.1 to 20 mm, more preferably 0.5 to 10 mm, and further preferably 0.5 to 5 mm.

The molded article having a plate-like portion can be produced by thermoforming the thermoplastic resin composition. Examples of the thermoforming method include an injection molding method, an extrusion method, a compression molding method, an inflation molding method, a blow molding method, a vacuum molding method, a pressure forming method, a laser processing method, a welding method, a heat adhesion method, and the like, and the thermoplastic resin composition of the present invention may be molded by any processing method that includes a heat melting step. The thermoforming method is preferably an injection molding method, an extrusion method or a compression molding method from the viewpoint of performing thermoforming using pellets of the thermoplastic resin composition and forming through-holes by a machining or laser processing the obtained molded article in step (II). In particular, an injection molding method is preferred from the viewpoint of improving production efficiency, and an extrusion method is preferred from the viewpoint of obtaining higher dimensional stability.

The thermoforming conditions of step (I) depend on the melting point or glass transition temperature of the thermoplastic resin (A) used, but when the thermoplastic resin (A) contains the polyimide resin (a1-1), step (I) preferably includes a step of thermoforming the thermoplastic resin composition at 290 to 380°C. Thermoforming at a temperature above 380°C to 400°C is also possible, but from the viewpoint of suppressing deterioration of the thermoplastic resin (A) and other components, it is preferable to perform the thermoforming at a temperature of 380°C or less. Examples of the specific procedure include the following methods.

First, the thermoplastic resin (A) is dry blended with the inorganic filler (B) and various optional components as necessary, then introduced into an extruder, melted at preferably 290 to 380°C, and melt-kneaded in the extruder and extruded to produce pellets. Alternatively, the thermoplastic resin (A) may be introduced into the extruder, melted at preferably 290 to 380°C, the inorganic filler (B) and various optional components as necessary introduced thereto and melt-kneaded with the thermoplastic resin (A) in the extruder, and extruded to produce the pellets.

The pellets may be dried, then introduced in various kinds of molding machines, and heat-molded preferably at from 290 to 380°C, thereby producing a molded article having a plate-like portion.

The molded article obtained by the above-described thermoforming may be formed into a desired shape by further subjecting it to a machining process and the like. For example, an injection-molded article can be produced using the thermoplastic resin composition, and then formed into a desired shape by subjecting it to a machining process.

It is preferred to further subject the molded article obtained by the above-described thermoforming to an annealing treatment from the viewpoint of further improving the machining processability of the molded article and microfabricability in step (II). The molded article obtained by further performing an annealing treatment after thermoforming the thermoplastic resin composition can, when subjected to a machining process, have a low surface roughness on the machined surface, and obtain, when the molded article has a plate shape, a flat plate having less warpage. Further, using the flat plate, a plurality of through-holes can be formed more precisely.

The annealing treatment of the molded article is preferably carried out after the thermoforming in step (I) and before the machining process. Alternatively, the annealing treatment may be carried out after the thermoforming process in step (I) and before the machining process, and then again after the machining process.

The annealing treatment temperature can be set according to the type of the thermoplastic resin (A) used. When the thermoplastic resin (A) is the crystalline thermoplastic resin (a1), the annealing treatment temperature is set to be lower than the melting point of crystalline thermoplastic resin (a1) from the viewpoint of avoiding deformation of the molded article, and taking the melting point of the crystalline thermoplastic resin (a1) to be Tm (°C), the annealing treatment temperature preferably is set in the range of Tm -100°C to Tm -20°C from the viewpoint of further improving machining processability and microfabricability of the molded article and the viewpoint of avoiding deformation of the molded article. When the thermoplastic resin (A) is the amorphous thermoplastic resin (a2), the annealing treatment temperature is lower than the glass transition temperature of the amorphous thermoplastic resin (a2) from the viewpoint of avoiding deformation of the molded article, and taking the glass transition temperature of the amorphous thermoplastic resin (a2) to be Tg (°C), the annealing treatment temperature preferably is set in the range of Tg -100°C to Tg -20°C from the viewpoint of further improving machining processability and microfabricability of the molded article and the viewpoint avoiding deformation of the molded article.

A specific example of the annealing treatment temperature is, when the thermoplastic resin (A) contains the polyimide resin (a1-1), a temperature in the range of preferably 200 to 360°C, more preferably 220 to 340°C, further preferably 240 to 330°C, and still further preferably 250 to 320°C, from the viewpoint of further improving machining processability and microfabricability of the molded article, and the viewpoint of avoiding deformation of the molded article.

The annealing treatment time is not particularly limited, but is preferably in the range of 1 to 180 minutes, and more preferably 5 to 150 minutes from the viewpoint of further improving the machining processability and microfabricability of the molded article, and the viewpoint of improving manufacturing efficiency.

The annealing treatment of the molded article can be performed using a known heating device.

After the annealing treatment, the molded article is gradually cooled to a temperature of preferably 100°C or less from the viewpoint of suppressing the occurrence of warping of the molded article due to residual stress.

From the viewpoint of improving microfabricability in step (II), the surface of the plate-like portion of the molded article preferably has a low surface roughness. For example, the arithmetic average roughness (Ra) of the surface of the plate-like portion of the molded article is preferably 1 µm or less, more preferably 0.8 µm or less, further preferably 0.6 µm or less, and still further preferably 0.3 µm or less.

The arithmetic average roughness (Ra) of the surface of the plate-like portion can be determined, for example, by measuring the arithmetic average roughness of a continuous area having a length of 20 mm using a 3D shape measuring instrument ("VR-6000", manufactured by Keyence Corporation).

### <Step (II)>

In step (II), a plurality of through-holes are formed in the plate-like portion of the molded article obtained in step (I) by a machining process or a laser processing. The method for producing a member of the present invention enables high-precision microfabrication to be performed even when a large number of through-holes are formed at a narrow pitch in step (II).

In step (II), a power drill or the like can be used to form the through-holes by a machining process. A laser instrument or the like can be used to form the through-holes by a laser processing.

From the viewpoint of achieving higher-precision microfabrication, the processing method in step (II) is preferably the laser processing. The laser processing conditions are not particularly limited, and the microfabrication can be performed using, for example, a laser beam with a wavelength of 266 to 1066 nm. A UV laser with a wavelengths around 355 nm or a deep ultraviolet laser with a wavelength around 266 nm is particularly suitable because such a laser has a high absorption rate of polyimide-based materials.

### Examples

The present invention will be described in more detail with reference to examples below, but the present invention is not limited thereto. Further, various measurements and evaluations in each Production Example and Example were carried out in the following manner.

### <Infrared spectroscopy (IR measurement)>

The IR measurement of the polyimide resin was performed with "JIR-WINSPEC 50", produced by JEOL, Ltd.

### <Logarithmic viscosity µ>

The polyimide resin was dried at from 190 to 200°C for 2 hours, and then 0.100 g of the polyimide resin was dissolved in 20 mL of concentrated sulfuric acid (96%, produced by Kanto Chemical Co., Inc.) to form a polyimide resin solution, and the measurement was made at 30°C with a Cannon-Fenske viscometer using the polyimide resin solution as a measurement sample. The logarithmic viscosity µ was obtained according to the following expression.$μ = ln \left(ts/{t}_{0}\right) / C$
t₀: elapsed time for flowing concentrated sulfuric acid
ts: elapsed time for flowing polyimide resin solution
C: 0.5 g/dL

### <Melting point, glass transition temperature, crystallization temperature, heat of melting, and heat of crystallization>

The melting point Tm, glass transition temperature Tg, crystallization temperature Tc, heat of melting Hm, and heat of crystallization Hc of the polyimide resin were measured with a differential scanning calorimeter ("DSC-25", manufactured by TA Instruments).

The measurement sample was subjected to the following thermal history under a nitrogen atmosphere (nitrogen gas flow rate: 50 mL/min). The condition of the thermal history included the first heating (heating rate: 10°C/min), then cooling (cooling rate: 20 °C/min), and then second heating (heating rate: 10°C/min).

The melting point Tm was determined by reading the peak top value of the endothermic peak observed in the second heating. The glass transition temperature (Tg) was determined by reading the value observed in the second heating. The crystallization temperature (Tc) was determined by reading the peak top value of the exothermic peak observed in cooling. For the Tm, Tg, and Tc, when a plurality of peaks were observed, the peak top value of each peak was read.

The heat of melting Hm (mJ/mg) was calculated from the area of the heat of melting peak (endothermic peak) observed near the melting point when the measurement sample was heated to a temperature equal to or more than the melting point at a heating rate of 10 °C/min to melt, then cooled at a cooling rate of 20 °C/min, and melted again at a heating rate of 10 °C/min. The heat of crystallization Hc (mJ/mg) was calculated from the area of the crystallization exothermic peak observed when the measurement sample was heated to a temperature equal to or more than the melting point at a heating rate of 10 °C/min to melt, and then cooled at a cooling rate of 20 °C/min.

### <Crystallization half-time>

The crystallization half-time of the polyimide resin was measured with a differential scanning calorimeter ("DSC-6220", produced by SII Nanotechnology, Inc.).

The polyimide resin was held at 420°C for 10 minutes in a nitrogen atmosphere so as to completely melt, then quenched at a cooling rate of 70 °C/min, and the time required from the appearance of the observed crystallization peak to the peak top thereof was calculated. In Table 1, semi-crystallization times of 20 seconds or less are indicated as "< 20."

### <Weight average molecular weight>

The weight average molecular weight (Mw) of the polyimide resin was measured with a gel permeation chromatography (GPC) measurement apparatus "Shodex GPC-101" produced by Showa Denko K.K. under the following conditions:
Column: Shodex HFIP-806M
Mobile phase solvent: HFIP containing 2 mM sodium trifluoroacetate
Column temperature: 40°C
Flow rate of mobile phase: 1.0 mL/min
Specimen concentration: about 0.1 mass%
Detector: IR detector
Amount of injection: 100 µm
Calibration curve: standard PMMA

### Production Example 1 (Production of crystalline thermoplastic polyimide resin 1)

500 g of 2-(2-methoxyethoxy)ethanol (produced by Nippon Nyukazai Co., Ltd.) and 218.12 g (1.00 mol) of pyromellitic dianhydride (produced by Mitsubishi Gas Chemical Company, Inc.) were introduced in a 2 L separable flask equipped with a Dean-Stark apparatus, a Liebig condenser tube, a thermocouple, and a four-paddle blade. After creation of a nitrogen flow, the mixture was agitated at 150 rpm so as to become a homogeneous suspended solution. On the other hand, 49.79 g (0.35 mol) of 1,3-bis(aminomethyl)cyclohexane (produced by Mitsubishi Gas Chemical Company, Inc., cis/trans ratio = 7/3) and 93.77 g (0.65 mol) of 1,8-octamethylenediamine (produced by Kanto Chemical Co., Inc.) were dissolved in 250 g of 2-(2-methoxyethoxy)ethanol with a 500 mL beaker, thereby preparing a mixed diamine solution. This mixed diamine solution was added into the suspended solution gradually with a plunger pump. Heat was generated due to the drop addition, but the internal temperature was adjusted to be within the range of 40 to 80°C. The dropwise addition of the mixed diamine solution was carried out in a nitrogen flow state over the whole period. The number of rotations of the agitation blade was set to 250 rpm. After the completion of the dropwise addition, 130 g of 2-(2-methoxyethoxy)ethanol and 1.284 g (0.01 mol) of n-octylamine (produced by Kanto Chemical Co., Inc.) as an end capping agent were added thereto, and the mixture was further agitated. At this stage, a pale yellow polyamic acid solution was obtained. Next, the agitation speed was set to 200 rpm, and the polyamic acid solution in the 2 L separable flask was then heated to 190°C. In this heating process, the deposition of a polyimide resin powder and dehydration associated with imidization were confirmed at a solution temperature of from 120 to 140°C. The solution was kept at 190°C for 30 minutes, then allowed to cool to room temperature, and filtered. The obtained polyimide resin powder was washed with 300 g of 2-(2-methoxyethoxy)ethanol and 300 g of methanol, filtered, and then dried in a dryer at 180°C for 10 hours to obtain 317 g of powder of a crystalline thermoplastic polyimide resin 1 (hereinafter simply referred to as "polyimide resin 1").

The measurement of the IR spectrum of polyimide resin 1 showed the characteristic absorption of an imide ring ν(C=O) observed at 1768 and 1697 (cm⁻¹). The logarithmic viscosity was 1.30 dL/g, Tm was 323°C, Tg was 184°C, Tc was 266°C, the heat of melting was 21.0 mJ/mg, the heat of crystallization was 20.3 mJ/mg, the crystallization half-time was 20 seconds or less, and Mw was 55,000.

Table 1 shows the composition and physical property evaluation results of polyimide resin 1 obtained in Production Example 1. The values expressed in mol% of the tetracarboxylic acid component and the diamine component in Table 1 are values calculated from the charged amount of each component in production of the polyimide resin.

### [Table 1]

**Table 1**

| | | Tetracarboxylic acid component (mol% in total tetracarboxylic acid component) | Diamine component (mol% in total diamine component) | | (1)/{(1)+(2)} (mol%) *1 | End capping agent (molar amount with respect to 1 mole of tetracarboxylic acid component) | Tm (°C) | Tg (°C) | Tc (°C) | Heat of melting Hm (mJ/mg) | Heat of crystallization Hc (mJ/mg) | Semi-crystallization time (sec) | Mw |
|---|---|---|---|---|---|---|---|---|---|---|---|---|---|
| | | PMDA | 1,3-BAC | OMDA | | n-OcA | | | | | | | |
| Production Example 1 | Polyimide resin 1 | 100 | 35 | 65 | 35 | 0.01 | 323 | 184 | 266 | 21.0 | 20.3 | <20 | 55,000 |

| | | | | | | | | | | | | | |
|---|---|---|---|---|---|---|---|---|---|---|---|---|---|
| *1: Content ratio (mol%) of the repeating structural unit of the formula (1) with respect to the total of the repeating structural unit of the formula (1) and the repeating structural unit of the formula (2) in the polyimide resin | | | | | | | | | | | | | |

The abbreviations in the table 1 are as follows.
- PMDA; pyromellitic dianhydride
- 1,3-BAC; 1,3-bis(aminomethyl)cyclohexane
- OMDA; 1,8-octamethylenediamine
- n-OcA; n-octylamine

### Example 1

### [Production of thermoplastic resin composition]

The component (A) and the component (B) shown in Table 2 were thoroughly mixed by dry blending. The obtained mixed powder was mixed with a co-rotating twin screw extruder ("HK-25D-41D", manufactured by Parker Corporation, screw diameter: 25 mm) at a barrel temperature of 360°C and a screw rotation speed of 120 rpm, and extruded in strands having a diameter of 2 to 3 mm.

The strands extruded from the extruder were air cooled, and then pelletized by a pelletizer ("Fan Cutter FC-Mini-4/N", produced by Hoshi Plastic Co., Ltd.).

### [Step (I): Production of plate-shaped molded article]

Pellets (thermoplastic resin composition) obtained by the above-described method were dried at 150°C for 10 hours, and then injection-molded in the following manner to produce a plate-shaped molded article. The injection molding of the thermoplastic resin composition was performed at a barrel temperature of 375°C, a mold temperature of 200°C, and a molding cycle of 60 seconds with an injection-molding machine ("ROBOSHOT α-S30iA", produced by FANUC Corporation), and a plate-shaped injection-molded article 100 having a diameter of 40 mm and a thickness of 4 mm was produced. The injection-molded article 100 was heated in a hot air dryer at 300°C for 60 minutes and subjected to an annealing treatment.

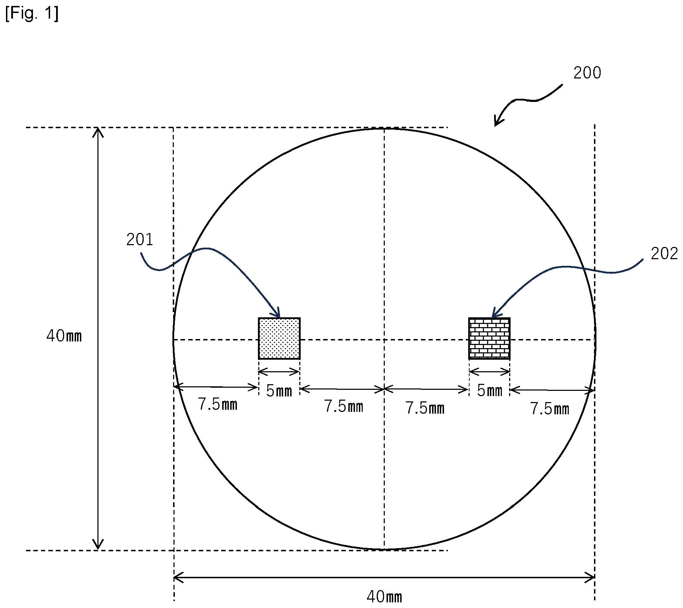

Next, 5 mm × 5 mm × 3 mm deep pockets were drilled into one side of the obtained injection-molded article 100 at the positions shown in Fig. 1 to produce a molded article 200.

Here, Fig. 1 is a schematic plan view of the molded article 200 produced in the above step (I) of Example 1, in which numerals 201 and 202 indicate the pockets.

### [Step (II): Through-hole formation and evaluation]

Next, a plurality of through-holes were formed by a laser processing in a portion (central portion) of the bottom surface of the pockets 201 and 202 of the molded article 200 produced in step (I).

Specifically, 1,000 through-holes with a circular opening and an opening diameter of 25 µm were formed in the central portion of the bottom surface of the pocket 201, with a pitch of 32 µm and partitions of 7 µm. Further, 1,000 through-holes with a square opening and a side length of 30 µm were formed in the central portion of the bottom surface of the pocket 202, with partitions of 7 µm.

The laser processing was performed using a laser instrument manufactured by Kataoka Corporation.

The shapes of the formed through-holes were evaluated as follows. The evaluation results are shown in Table 2.

### (Microfabrication Evaluation-1)

The through-holes formed by the above method were observed with a digital microscope ("VHX-7000," produced by Keyence Corporation, magnification: 150x), and the microfabrication state was evaluated for the following items based on the following criteria.

### <Appearance (presence/absence of partition fracture and discoloration)>

A: No partition fracture or discoloration observed.
C: Partition fracture or discoloration observed.

### <Burr state>

A: No burrs observed.
B: Burrs present, but could be removed by air blasting.
C: Numerous burrs present, making removal by air blasting difficult.

### (Microfabrication Evaluation-2)

The opening shape of the through-holes formed using the above method was observed and measured using a high-resolution image dimension measuring device ("LM Series" produced by Keyence Corporation), and the opening shape was evaluated for the following items based on the following criteria.

### <Roundness>

A: All through-holes with a circular opening had an opening diameter within the range of 25.0 ±0.5 µm.
C: Some through-holes with a circular opening had an opening diameter that exceeded the range of 25.0 ±0.5 µm.

### <Squareness>

For all the through-holes with a square opening, the curvature of the right-angled opening was measured. The average curvature was calculated as the radius R (µm), and is shown in Table 2. The smaller the R value, the closer the angle is to a right angle, indicating higher-precision processing.

### [Example 2]

Production of the molded article, step (II), and the various evaluations were carried out in the same manner as in Example 1, except that the method used in step (I) of Example 1 to mold the plate-shaped molded article used was changed to extrusion method, and the annealing temperature was changed to the temperature shown in the table. The evaluation results are shown in Table 2. Specifically, step (I) was carried out by the following method.

### [Step (I)]

Pellets (thermoplastic resin composition) obtained in the same manner as in Example 1 were dried at 150°C for 10 hours, and then extrusion-molded in the following manner to produce a plate-shaped molded article.

The extrusion molding of the thermoplastic resin composition was performed at an extrusion temperature of 360°C using an extrusion molding machine ("FS30", produced by Ikegai Corporation). Next, a machining process was carried out to produce a plate-shaped extrusion-molded article 110 having a diameter of 40 mm and a thickness of 4 mm. The extrusion-molded article 110 was heated in a hot air dryer at 260°C for 120 minutes and subjected to an annealing treatment. Two 5 mm × 5 mm × 3 mm deep pockets were drilled into one side of the obtained extrusion-molded article 110 in the same manner as in Example 1 to produce a molded article 210.

The injection-molded article 100 and the extrusion-molded article 110 have the same shape, and the molded articles 200 and 210 have the same shape.

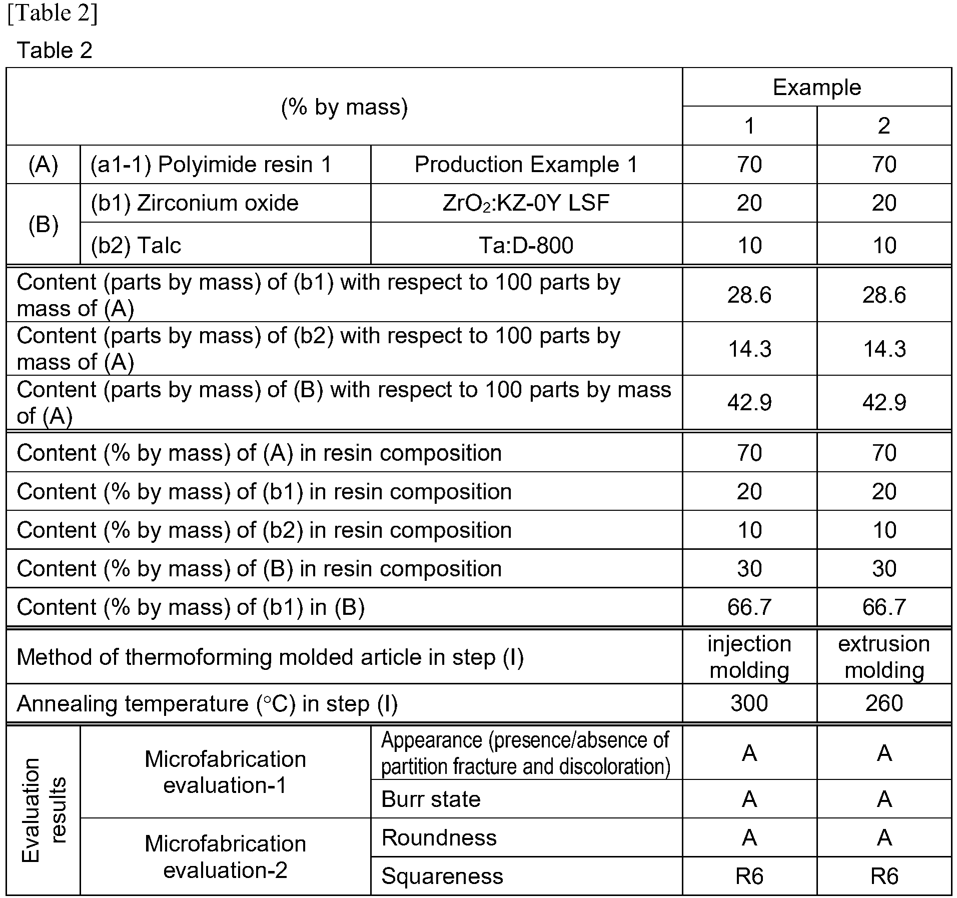

The details of each component shown in Table 2 are as follows.

### <Thermoplastic resin (A)>

### (a1-1) Polyimide resin 1 obtained in Production Example 1

### <Inorganic filler (B)>

(b1) Zirconium oxide, high purity zirconia "KZ-0Y-LSF", manufactured by KCM Corporation, spherical particles, D50: 0.2 µm
(b2) Talc, "Nano Ace D-800", manufactured by Nippon Talc Co., Ltd., plate-shaped particles, D50: 0.8 µm

As shown in Table 2, the members of the above-described examples had few burrs even when a plurality of fine through-holes were formed at a narrow pitch, there was little partition fracture or discoloration, as well as little variation in the opening shape of the through-holes. Further, even when the opening shape was square, the shape was highly reproducible, demonstrating the use of high-precision microfabrication.

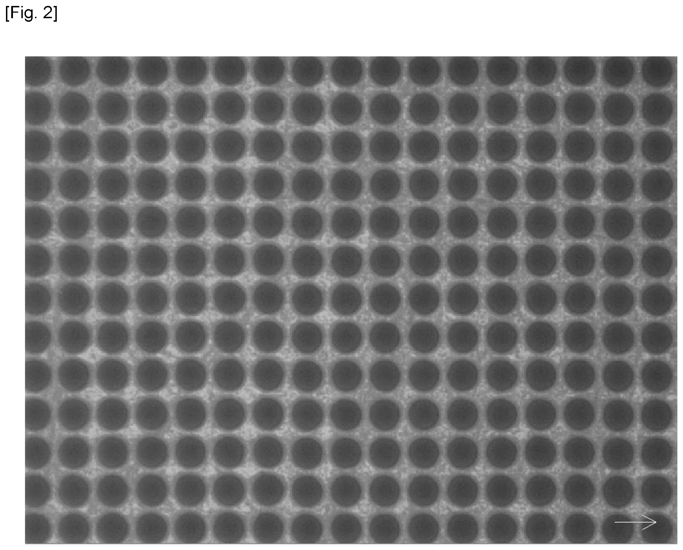

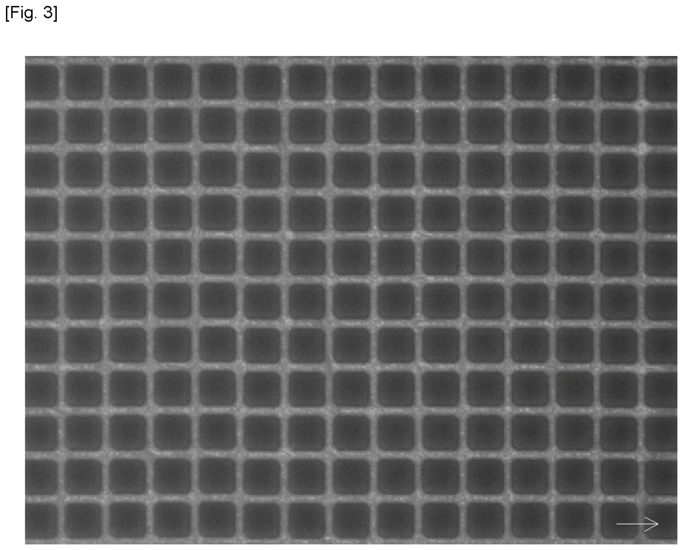

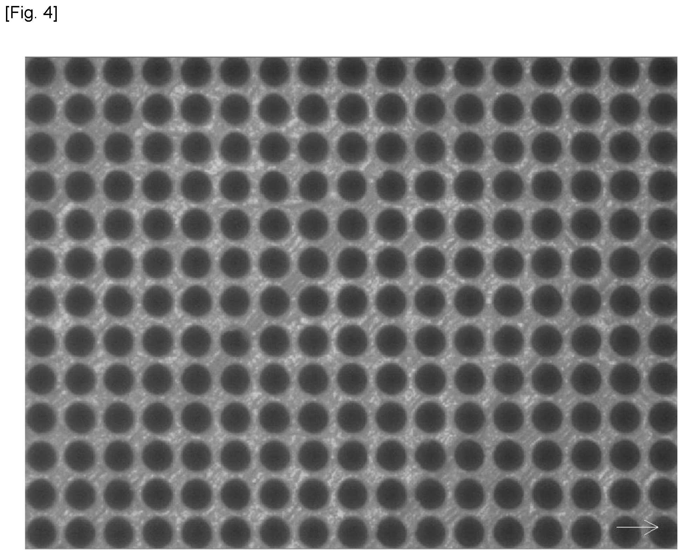

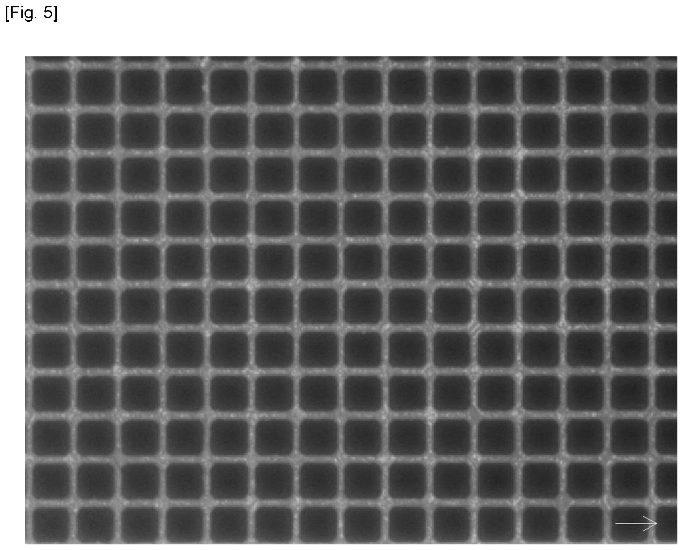

Figs. 2 to 5 show images of the through-holes formed in step (II) of Examples 1 and 2 observed from above with the above-described digital microscope (magnification: 150x). Fig. 2 is an observation image of through-holes having a circular opening shape produced in Example 1. Fig. 3 is an observation image of through-holes having a square opening shape produced in Example 1. Fig. 4 is an observation image of through-holes having a circular opening shape produced in Example 2. Fig. 5 is an observation image of through-holes having a square opening shape produced in Example 2.

### Industrial Applicability

According to the present invention, a member for a probe card or a member for a printed board inspection jig, as well as a production method thereof, that has undergone high-precision microfabrication with little occurrence of burrs or the like, in particular even when fine through-holes are formed by a laser processing can be provided.

### Reference Signs List

200: molded article produced in step (I) of Example 1
201, 202: pockets

## Claims

1. A member for a probe card or a member for a printed board inspection jig, the member being composed of a thermoplastic resin composition comprising:
a component (A) which is at least one thermoplastic resin selected from the group consisting of a crystalline thermoplastic resin (a1) having a melting point of 270°C or more and an amorphous thermoplastic resin (a2) having a glass transition temperature of 200°C or more; and
a component (B) which is an inorganic filler comprising a zirconium oxide (b1), wherein
a content of the component (b1) is 2 to 40 parts by mass with respect to 100 parts by mass of the component (A), and a content of the component (B) is 2 to 60 parts by mass with respect to 100 parts by mass of the component (A).

2. The member according to claim 1, wherein the component (a1) comprises a polyimide resin (a1-1) comprising a repeating structural unit represented by the following formula (1) and a repeating structural unit represented by the following formula (2), a content ratio of the repeating structural unit of formula (1) to the total of the repeating structural unit of formula (1) and the repeating structural unit of formula (2) being 20 to 70 mol%: 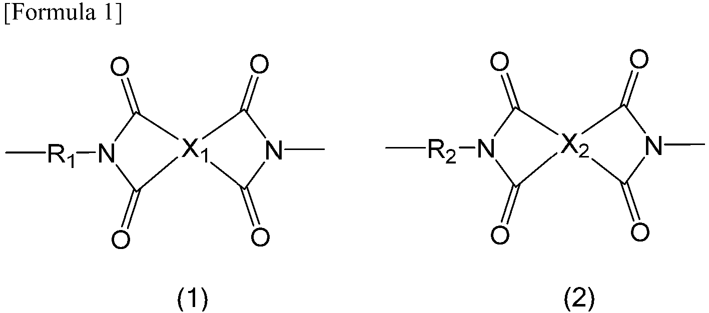 wherein R₁ represents a divalent group having from 6 to 22 carbon atoms containing at least one alicyclic hydrocarbon structure; R₂ represents a divalent chain aliphatic group having from 5 to 16 carbon atoms; and X₁ and X₂ each independently represent a tetravalent group having from 6 to 22 carbon atoms containing at least one aromatic ring.

3. The member according to claim 1 or 2, wherein the zirconium oxide (b1) has a volume median diameter (D50) of 1 µm or less.

4. The member according to any one of claims 1 to 3, wherein a total content of the component (A) and the component (B) in the thermoplastic resin composition is 50% by mass or more.

5. The member according to any one of claims 1 to 4, wherein the component (B) further comprises an inorganic filler (b2) other than the component (b1), and the inorganic filler (b2) comprises at least one selected from the group consisting of talc, mica, silica, alumina, silicon nitride, aluminum nitride, boron nitride, silicon carbide, boron carbide, calcium carbonate, and titanium oxide.

6. The member according to claim 5, wherein a content of the inorganic filler (b2) is 1 to 40 parts by mass with respect to 100 parts by mass of the component (A) in the thermoplastic resin composition.

7. The member according to any one of claims 1 to 6, wherein the member is a member having a plate-like portion, and having, on the plate-like portion, a plurality of through-holes, each of which has a substantially circular opening with a diameter of 400 µm or less or a substantially square opening with a side length of 400 µm or less.

8. The member according to any one of claims 1 to 7, wherein the member is a holding member of a probe or a guide member of a probe.

9. A method for producing the member for a probe card or the member for a printed board inspection jig according to any one of claims 1 to 8, comprising the following step (I) and step (II) in this order:
Step (I): a step of molding a thermoplastic resin composition by a thermoforming method to obtain a molded article having a plate-like portion, the thermoplastic resin composition comprising:
a component (A) which is at least one thermoplastic resin selected from the group consisting of a crystalline thermoplastic resin (a1) having a melting point of 270°C or more and an amorphous thermoplastic resin (a2) having a glass transition temperature of 200°C or more; and
a component (B) which is an inorganic filler comprising a zirconium oxide (b1), wherein
a content of the component (b1) is 2 to 40 parts by mass with respect to 100 parts by mass of the component (A), and a content of the component (B) is 2 to 60 parts by mass with respect to 100 parts by mass of the component (A),
Step (II): a step of forming a plurality of through-holes in the plate-like portion of the molded article by a machining process or a laser processing.

10. The production method according to claim 9, wherein the thermoforming method in step (I) is an injection molding method, an extrusion method, or a compression molding method.

11. The production method according to claim 9 or 10, wherein a processing method in step (II) is the laser processing.
